Europäisches Patentamt

European Patent Office

Office européen des brevets

(19)

(11) Veröffentlichungsnummer: **0 226 574**
**B1**

(12) **EUROPÄISCHE PATENTSCHRIFT**

(45) Veröffentlichungstag der Patentschrift:
15.11.89

(21) Anmeldenummer: 85901981.2

(22) Anmeldetag: 25.04.85

(86) Internationale Anmeldenummer:
PCT/DE 85/00132

(87) Internationale Veröffentlichungsnummer:
WO 86/00677 (13.02.86 Gazette 86/04)

(51) Int. Cl.⁴: **G 01 D 5/16**, G 01 P 3/48,
G 01 V 3/08, H 01 L 43/08

(54) MAGNETORESISTIVER SENSOR ZUR ABGABE VON ELEKTRISCHEN SIGNALEN.

(30) Priorität: 20.07.84 DE 3426784

(43) Veröffentlichungstag der Anmeldung:
01.07.87 Patentblatt 87/27

(45) Bekanntmachung des Hinweises auf die Patenterteilung:
15.11.89 Patentblatt 89/46

(84) Benannte Vertragsstaaten:
DE FR GB IT

(56) Entgegenhaltungen:
EP-A-0 057 766
DE-A-2 532 981
FR-A-2 452 716
US-A-4 039 936

(73) Patentinhaber: ROBERT BOSCH GMBH, Postfach
50, D-7000 Stuttgart 1 (DE)

(72) Erfinder: ECKARDT, Dieter, Gibitzenhofstrasse 17,
D-8500 Nürnberg (DE)
Erfinder: HETTICH, Gerhard, Martin- Renz- Strasse
8, D-8501 Dietenhofen (DE)

EP 0 226 574 B1

**Beschreibung**

**Stand der Technik**

Die Erfindung geht aus von einem magnetoresistiven Sensor zur Abgabe von elektrischen Signalen nach dem ersten Teil von Anspruch 1.

Es ist bekannt, zum Abtasten magnetischer Bäder Leseköpfe zu verwenden, in denen magnetoresistive Meßstreifen senkrecht zum Magnetband angeordnet sind, die von einem Meßstrom durchflossen werden. Die auf dem Magnetband gespeicherten Informationen bestehen dabei aus kleinen Magnetfeldern, die in der Ebene der magnetoresistiven Meßstreifen liegen und beim Vorbeibewegen die Richtung der Magnetisierung im Meßstreifen beeinflussen. Durch die Magnetfeldkomponente, die in der Ebene des Meßstreifens liegt und mit der Stromrichtung im Meßstreifen einen Winkel bildet, wird der Widerstand des Meßstreifens geändert. Da der Meßstreifen über einen Vorwiderstand an eine Gleichspannung geschaltet ist, ändert sich mit dem Widerstand auch der Spannungsabfall am Meßstreifen, der als Meßsignal ausgewertet wird (Philips Technische Rundschau 37, 1977/78, Nr. 2/3, Seite 47 ff). Diese Lösung hat den Nachteil, daß sie nur zur Abtastung schwacher Magnetfelder zu verwenden ist, die auf einem bewegten Trager aufgebracht werden müssen. Ein solches Lösungsprinzip ist aber für eine Vielzahl von Sensoranwendungen, bei denen Magnetfelder bzw. Magnetfeldänderungen detektiert werden sollen, schon deswegen ungeeignet, weil das Magnetband oder ein anderer Magnetfeldträger praktisch ohne Luftspalt am Lesekopf vorbeigeführt werden muß. Außerdem können am Lesekopf oder am Magnetband Störfelder das Meßergebnis verfälschen bzw. die zu detektierenden Magnetfelder verändern.

Aus der EP-A-57 766 sind ferner magnetoresistive Sensoren bekannt, die in gleicher Weise die Annäherung eines Magneten und die Annäherung eines ferromagnetischen Körpers detektieren. Dort wird ebenfalls die Richtungsänderung eines Magnetfeldes bzw. einer die Intensitätsänderung eines Magnetfeldes zur Messung verwendet. Derartige Sensoren sind daher empfindlich gegen Störfelder sowie gegen Veränderungen und Toleranzen im Luftspalt zwischen dem Dauermagneten und dem ferromagnetischen Körper.

Darüber hinaus ist es aus der US-A-4 039 936 bekannt, magnetoresistive Sensoren zum Detektieren von ferromagnetischen Körpern zu verwenden, die relativ zu den ferromgnetischen Sensorelementen in Form einer Zahnstange oder Zahnscheibe bewegt werden. Dort wird beim Vorbeibewegen der Zähne dieser Zahnstange bzw. Zahnscheibe die Stärke der die magnetoresistiven Sensorelemente durchsetzende Gleichfeldkomponente verändert und dadurch das erforderliche Meßsignal gewonnen. Durch die große Änderung des Luftspaltes zwischen den Sensorelementen und dem relativ dazu bewegbaren weichmagnetischen Körper ergibt sich zwar eine ausreichende Änderung der Magnetfeldstärke in den Sensorelementen zur Erzeugung eines Sensorsignales; jedoch können auch hier die Meßsignale durch magnetische Störfelder verfälscht werden. Außer ist die Meßempfindlichkeit derartiger Sensoren für viele Anwendungsfälle unzureichend, so daß nur mit relativ großen Meßspannungen gearbeitet werden kann, die beispielsweise bei Anwendungen in Kraftfahrzeugen und dgl. nicht vorhanden sind.

Zur Auslösung von Schaltvorgängen ist es schließlich aus der DE-A-2 532 981 bekannt, magnetoresistive Sensoren als kontaktlose Schalter zu verwenden, indem sie in einer Brückenschaltung durch Annäherung eines magnetischen Gleichfeldes eine Brückenspannung erzeugen, die beim Erreichen eines vorgegebenen Schwellwertes einen Schaltvorgang auslösen. Auch diese Lösung hat den wesentlichen Nachteil, daß die Signalspannung durch magnetische Störfelder verfälscht wird, weil die in der Ebene der Meßstreifen liegende Magnetfeldkomponente relativ klein ist und nicht zur Sättigung der Meßstreifen führt. Eine Sättigung der Meßstreifen über den gesamten Meßbereich erreicht man bei dieser Veröffentlichung lediglich in der Ausführungsform nach Figur 14. Diese Anordnung ist jedoch sehr aufwendig, da sie einen zweiten Dauermagneten benötigt, dessen Magnetfeld zusammen mit dem Magnetfeld des beweglichen Dauermagneten eine magnetische Sättigung in den Meßstreifen unabhängig von der Richtung des resultierenden Feldes bewirkt. Außerdem muß hier zur Auslösung von Schaltsignalen für die Erzeugung des magnetischen Gleichfeldes ein Dauermagnet bewegt werden bzw. der zu detektierende Körper muß mit einem Dauermagnetfeld versehen sein.

Mit der vorliegenden Lösung wird angestrebt, einen stationären magnetoresistiven Sensor zu schaffen, der gegen Störfelder sowie gegen Veränderungen und Toleranzen im Luftspalt zwischen dem stationären Sensor und einem zu detektierenden weichmagnetischen, bewegbaren Körper weitgehend unempfindlich ist.

Die erfindungsgemäße Lösung wird mit den Merkmalen von Anspruch 1 erreicht. Dies hat den Vorteil, daß nicht mehr der am Sensor vorbeizubewegende Körper mit dauermagnetischen Feldern versehen werden muß, sondern daß stattdessen ein stationäres magnetisches Gleichfeld die magnetoresistiven Meßstreifen mit einer großen senkrecht durch die Meßstreifen gehenden Komponente des Gleichfeldes durchsetzt und ferner einen zu detektierenden, bewegbaren Körper mangetisiert. Dabei wird durch eine in der Ebene der Meßstreifen liegende Magnetfeldkomponente in an sich bekannter Weise eine magnetische Sättigung in den Meßstreifen erreicht. Aufgrund einer Richtungsänderung dieser Magnetfeldkomponente durch den bewegbaren ferromagnetischen Körper wird nunmehr als Signal eine Spannungsänderung an den Meßstreifen bewirkt, wobei Störfeldeinflüsse unterdrückt werden. Gegenüber bekannten induktiven Sensoren hat diese Lösung den Vorteil, daß auch bei einem statischen Betrieb, also auch bei einem stillgesetzten ferromagnetischen Körper dessen Lage im Bereich des magnetoresistiven Sensors ermittelt werden kann. Ferner ist gegenüber induktiven Sensoren ein wesentlich größerer Luftspalt zulässig und es tritt kein frequenzabhängiger Phasengang auf. Bei der Anwendung als Drehzahlsensor, der mit einem umlaufenden Zahnkranz zusammenwirkt, ist der erfindungsgemäße Sensor wesentlich unempfindlicher gegenüber Vibrationen oder axialem Schlag des Zahnkranzes als bekannte induktive Drehzahlsensoren.

Durch die in den abhängigen Ansprüchen aufgeführten Maßnahmen sind vorteilhafte Weiterbildungen und Verbesserungen der im Anspruch 1 angegebenen Merkmale möglich. Besonders vorteilhaft ist es dabei, das Substrat mit dem magnetoresistiven Meßstreifen an der Stirnseite eines Dauermagneten im Bereich einer Kante am Dauermagneten anzuordnen, wenn sich der ferromagnetische Körper, vorzugsweise ein umlaufender Zahnkranz mit Abstand an der Kante entlang bewegt, um am Ausgang des Sensors ein Drehzahlsignal abzugeben. Zur Bildung eines möglichst homogenen Magnetfeldes mit einer in Bezug auf die Meßstreifen vertikalen und einer horizontalen Magnetfeldkomponente hat es sich als zweckmäßig erwiesen, die Kante am Dauermagneten durch eine gut zu bilden, die sich in der Bewegungsrichtung des ferromagnetischen Körpers bzw. des Zahnkranzes über die ganze Stirnseite des Dauermagneten erstreckt.

## Zeichnung

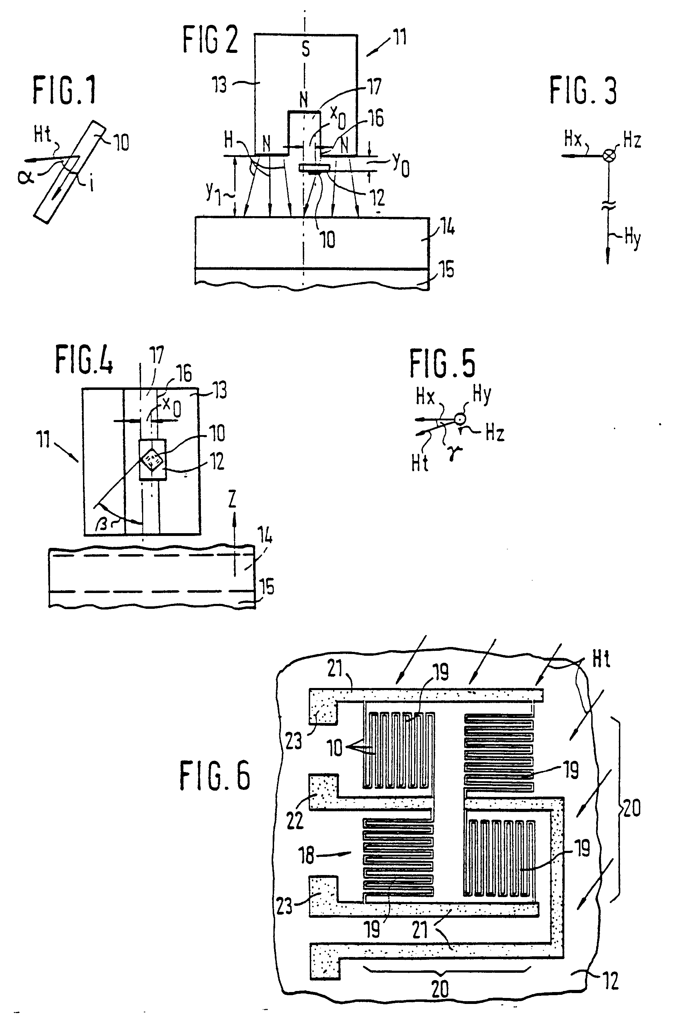

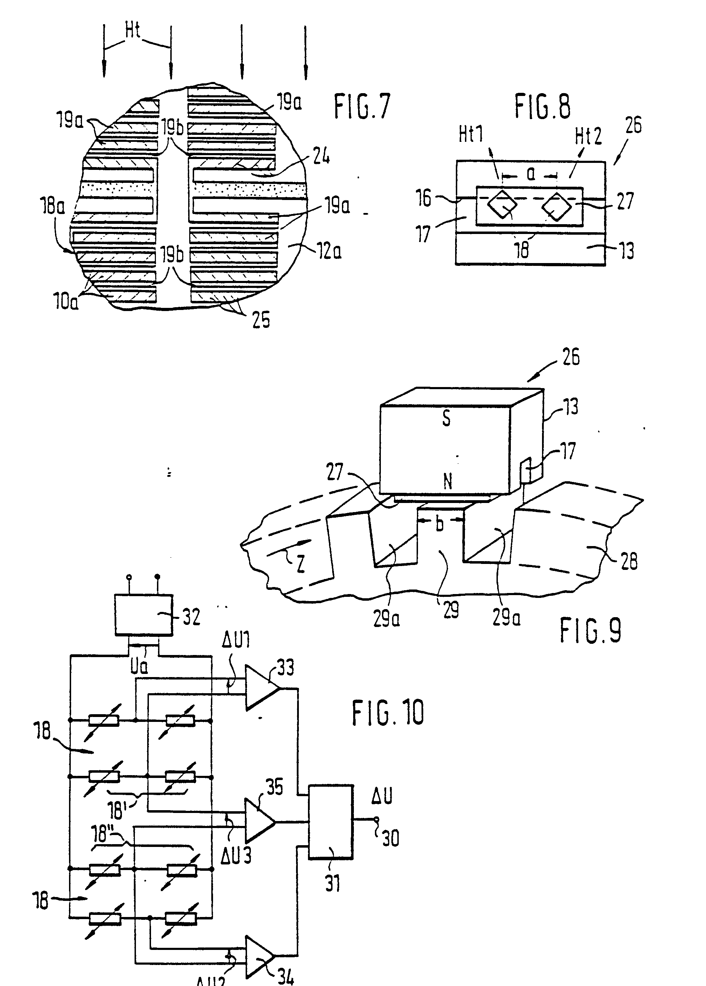

Drei Ausführungsbeispiele der Erfindung sind in der Zeichnung dargestellt und in der nachfolgenden Beschreibung näher erläutert. Es zeigen Figur 1 einen Meßstreifen des magnetoresistiven Sensors, Figur 2 einen magnetoresistiven Sensor mit einem Dauermagneten und einen umlaufenden weichmagnetischen Körper, Figur 3 zeigt die Komponenten des Magnetfeldes im Bereich der Meßstreifen des Sensors nach Figur 2. Figur 4 zeigt den Sensor nach Figur 2 in der Sicht von unten, Figur 5 zeigt die Komponenten des Magnetfeldes in der Ebene der Meßstreifen, Figur 6 zeigt die auf einem Substrat aufgebrachten Meßstreifen des Sensors in stark vergrößerter Darstellung und Figur 7 zeigt in einem zweiten Ausführungsbeispiel eine andere Anordnung der Meßstreifen, Figur 8 zeigt in einem dritten Ausführungsbeispiel einen magnetoresistiven Sensor mit zwei Brückenschaltungen von Meßstreifen, Figur 9 zeigt den Sensor aus Figur 8 in raumlicher Darstellung mit einem damit zusammenwirkenden Zahnkranz im Ausbruch und Figur 10 zeigt die Schaltungsanordnung der Meßstreifen mit der Eingang- und Ausgangsschaltung.

## Beschreibung der Ausführungsbeispiele

In Figur 1 ist von einer Vielzahl von Meßstreifen eines magnetoresistiven Sensors ein einzelner Meßstreifen dargestellt und mit 10 bezeichnet. Zur Erzeugung eines Meßsignales wird ein Meßstrom i in Längsrichtung durch den in der Zeichnungsebene liegenden Meßstreifen 30 geschickt. Beim Anlegen eines magnetischen Feldes, das eine in der Ebene des Meßstreifens 10 liegende sogenannte Tangentialkomponente Ht hat und mit der Richtung des Stromes i einen Winkel $\alpha$ bildet, verringert sich der Widerstand des Meßstreifens 10. Ist die Feldkomponente Ht groß genug, um den Meßstreifen 10 magnetisch zu sättigen so wird eine Änderung des Widerstandes im Meßstreifen 10 nur noch durch eine Änderung der Richtung der Feldkomponente Ht bewirkt. Die größte Widerstandsänderung wird nun dadurch erzielt, daß die Feldkomponente Ht zunächst in einer Grundeinstellung mit der Stromrichtung i einen Winkel $\alpha = 45°$ bildet. In dieser Grundeinstellung ist die Steigung ($\frac{dR}{d\alpha}$) der Kennlinie für die Widerstandänderung maximal, so daß bereits kleinste Richtungsänderungen der Feldkomponente Ht von weniger 1° durch eine entsprechende Auswerteschaltung sowie durch die Zusammenschaltung mehrerer solcher Meßstreifen 10 erfaßt werden können.

In den Figuren 2 und ist ein mit 11 bezeichneter magnetoresistiver Sensor dargestellt, bei dem mehrere in Figur 4 angedeutete Meßstreifen 10 auf einem Substrat 12 aufgebracht sind. Wie Figur 2 zeigt, ist das Substrat 12 mit einem darüber angeordneten Dauermagneten 13 stationär befestigt, wobei der Dauermagnet 13 in senkrechter Richtung magnetisiert ist. Unterhalb des Substrates 12 befindet sich ein weichmagnetischer Körper, der durch einen Zahn 14 eines umlaufenden Rades 15 gebildet ist. Dabei ist in Figur 2 die Längsseite des Zahnes 14 erkennbar. Das Substrat 12 mit den Meßstreifen 10 an der unteren Stirnseite des Dauermagneten 13 ist im Bereich einer Kante 16 des Dauermagneten 13 angeordnet, welche durch eine Nut 17 gebildet wird. Die Nut 17 erstreckt sich in der Bewegungsrichtung Z (Figur 4) des Zahnes 14 über die ganze Stirnseite des Dauermagneten 13. Das an der unteren Stirnseite des Dauermagneten 13 austretende Magnetfeld H ist durch die Nut 17 auf der gesamten Breite des Dauermagneten 13 nicht homogen. Dadurch werden die Meßstreifen 10 auf dem Substrat 12 von dem Magnetfeld H schräg durchsetzt. Figur 3 zeigt, daß dabei an den Meßstreifen 10 eine große Feldkomponente Hy senkrecht zu den Meßstreifen 10 und eine wesentlich kleinere Feldkomponente Hx in der Ebene der Meßstreifen 10 verläuft.

In Figur 4 ist der magnetoresistive Sensor 11 mit Sicht auf die untere Stirnseite des Dauermagneten 13 dargestellt. Dabei ist erkennbar, daß die Meßstreifen 10 zur Längsachse des Dauermagneten 13 einen Winkel $\beta = 45°$ bilden. Figur 5 zeigt die in der Ebene der Meßstreifen 10 wirkende Feldkomponente Ht, die sich aus der Feldkomponente Hx quer zur Nut 17 und aus der Feldkomponente Hz in Richtung der Nut 17 ergibt. Die Hauptkomponente Hy des Magnetfeldes H liegt hier senkrecht zur Zeichnungsebene.

Da das Substrat 12 mit den Meßstreifen 10 an der Stirnseite des Dauermagneten 13 auf halber Länge der Nut 17 angeordnet ist, ist die in der Ebene der Meßstreifen 10 wirksame Feldkomponente Ht identisch mit der quer zur Nut gerichteten Feldkomponente Hx des Magnetfeldes H, solange der Zahn 14 des Rades 15 sich dem Sensor 11 nicht nähert. In diesem Fall ist die Größe des Winkels $\alpha = \beta = 45°$. Die in Figur 5 erkennbare Feldkomponente Hz ist dann noch nicht vorhanden, und es gilt Hx = Ht. Sobald sich nun - wie in Figur 4 dargestellt - der gestrichelt erkennbare Zahn 14 des Rades 15 in Richtung Z dem Sensor 11 nähert, wird das Magnetfeld H des Dauermagneten 13 von diesem Zahn 14 abgelenkt und es tritt gemäß Figur 5 eine Feldkomponente Hz hinzu, durch die sich die Richtung der in der Ebene der Meßstreifen 10 liegenden Feldkomponente Ht um den Winkel $\gamma$ ändert. Je nach Lage der Meßstreifen 10 wird dadurch auch der Winkel $\alpha$ (Figur 1) größer bzw. kleiner. Es gilt:

$$\alpha = \beta \pm \gamma$$

Wird nun der Zahn 14 in Richtung Z am Sensor 11 vorbeibewegt, so wird zunächst die Feldkomponente Hz größer.

Erreicht der Zahn 14 die Mitte des Sensors 11, so verschwindet die Feldkomponente Hz wieder. Anschließend nimmt sie dann in entgegengesetzter Richtung wieder zu, um schließlich wieder zu verschwinden, wenn der Zahn 14 den Sensor 11 verlassen hat. Eine besonders ausgeprägte Richtungsänderung der Feldkomponente Ht ergibt sich bei einem Sensor 11, bei dem der Abstand der Meßstreifen 10 von der Stirnseite des Dauermagneten 13 $y_0 \approx 1,5$ mm beträgt und bei dem der Abstand $y_1$ der unteren Stirnseite des Dauermagneten 13 zum Zahn 14 etwa 2 bis 6 mm beträgt. Damit ist der Abstand $y_0$ kleiner gewählt als der Abstand $y_1 - y_0$ zwischen dem Zahn 14 und den Meßstreifen 10. Außerdem soll der Abstand der geometrischen Mitte aller Meßstreifen 10 von der Mittelachse des Dauermagneten 13 $x_0 \approx 1,5$ mm betragen, sowie die Nut 17 etwa 3 mm breit und $\approx 7$ mm tief sein.

Um an dem Sensor 11 durch Vorbeibewegen des Zahnes 14 eine möglichst große Meßspannung zu erzielen, werden die Meßstreifen 10 zu einer Brückenschaltung 18 mit vier Widerständen 19 miteinander verbunden, was in Figur 6 in stark vergrößertem Maßstab dargestellt ist. Dabei sind die nebeneinanderliegenden Meßstreifen 10 eines jeden Widerstandes 19 der Brückenschaltung 18 mäanderförmig in Reihe geschaltet. Die Widerstände 19 sind auf einem quadratischen Bereich 20 des Substrates 12 in jeweils einem der vier Quadranten aufgebracht.

Durch enge räumliche Anordnung wird erreicht, daß in diesem Bereich 20 die in der Ebene der Meßstreifen 10 liegende Feldkomponente Ht im Bereich der Widerstände 19 eine weitgehend homogene Feldstärke aufweist. Die Enden der Widerstände 19 sind mit Leiterbahnen 21 kontaktiert, an deren Enden Kontaktflächen 22 und 23 gebildet sind. Die Kontaktflächen 22 dienen zur Spannungsversorgung der Brückenschaltung 18 durch Anlegen einer Gleichspannung, während die Kontaktflächen 23 zum Abgriff einer Meßspannung an der Brückendiagonalen verwendet werden. Eine relativ große Meßspannung erhält man an einer Brückenschaltung immer dann, wenn sich die diagonal gegenüberliegenden Widerstände der Brückenschaltung in gleicher Richtung und die in ein- und demselben Brückenzweig liegenden Widerstände in entgegengesetzter Richtung verändern. Dies wird bei der Brückenschaltung 18 des Sensors 11 durch die Feldkomponente Ht dadurch erreicht, daß die Meßstreifen 10 eines jeden Widerstandes 19 in ihrer Längsrichtung zu den Meßstreifen der benachbarten Widerstände um 90° gedreht sind. Bei einer solchen, in Figur 6 dargestellten Anordnung der Meßstreifen 10 wird beim Vorbeibewegen des Zahnes 14 am Sensor 11 eine von der Umlaufgeschwindigkeit des Zahnes unabhängige Meßspannung erzielt, die bei einer angelegten Gleichspannung von Ua = 10 V bis zu $\Delta U = 200$ mV beträgt.

In Figur 7 ist in einem weiteren Ausführungsbeispiel des Sensors 11 ein Ausbruch aus der Brückenschaltung 18a dargestellt, bei der die Widerstände 19a auf dem Substrat 12a aus mäanderförmig nebeneinander angeordneten in Reihe geschalteten Meßstreifen 10a bestehen, deren Längsrichtung mit dem Meßstreifen 10a der benachbarten Widerstände 19 gleich ist. Die Meßstreifen 10a sind hier jedoch durch elektrisch gut leitende Goldbahnen 19b miteinander verbunden und durch Goldfäden 24 in einzelne Bahnabschnitte 25 aufgegliedert. Dabei liegen die Fäden 24 im Winkel von 45° zur Längsrichtung der Meßstreifen 10. Durch die Fäden 24 wird der durch die Meßstreifen 10 fließende Strom um etwa 45° aus der Längsrichtung gedreht. Solche Anordnungen sind unter dem Namen Barber-Pole bei Tonköpfen bekannt. Um auch hier durch die in der Ebene der Meßstreifen 10a liegende Feldkomponente Ht eine entgegengesetzte Widerstandsänderung in den Widerständen eines Brückenzweiges zu bekommen, verlaufen die Fäden 24 auf dem Meßstreifen 10a eines jeden Widerstandes 19a der Brückenschaltung 18a jeweils unter 90° gedreht zu den Fäden 24 der benachbarten Widerstände 19a.

In den Figuren 8 bis 10 ist ein weiteres Ausführungsbeispiel eines erfindungsgemäßen Sensors 26 dargestellt, bei dem an der unteren Stirnseite des stationär befestigten Dauermagneten 13 ein Substrat 27 befestigt ist, auf dem im Bereich der Kante 16 des Dauermagneten 13 zwei Brückenschaltungen 18 angeordnet sind. Die Brückenschaltungen 18 sind gemäß Figur 6 aus mehreren, zu Brückenwiderständen 19 zusammengeschalteten Gruppen von Meßstreifen 10 gebildet. Sie liegen in Richtung der Nut 17 und damit in Richtung Z eines umlaufenden Zahnkranzes 28 (Figur 9) in einem Abstand a hintereinander und symmetrisch zum Halbierungspunkt der Nutlänge.

Die Brückenschaltungen 18 sind dort angebracht, wo die tangentiale Magnetfeldkomponente Ht eine weitgehend homogene Feldstärke hat, die so groß ist, daß sämtliche Meßstreifen 10 bis in die Sättigung magnetisiert sind. Durch die Anordnung von zwei Brückenschaltungen 18 werden Offsetspannungen ausgeglichen, die an den Brückendiagonalen durch Unsymmetrien beim Anbringen des Substrates 27 an der Stirnseite des Dauermagneten 13 auftreten können. Subtrahiert man die beiden Meßspannungen an den Brückenschaltungen 18 voneinander, so kompensieren sich deren Offsetspannungen und man erhält ein Ausgangssignal $\triangle U = \triangle U1 - \triangle U2$ (Figur 10). Wählt man den Mittenabstand a der beiden Brückenschaltungen 18 etwa so groß wie die Zahnbreite b des Zahnkranzes 18 und diese wiederum so groß wie die Zahnlücken 29a, so erhält man beim Durchlaufen eines jeden Zahnes 29 am Sensor 26 eine Meßspannung $\triangle U$ am Ausgang 30 der Verknüpfungsschaltung 31 (Figur 10), die etwa doppelt so groß wie die Meßspannung $\triangle U1$ und $\triangle U2$ an den beiden Brückenschaltungen 18 ist. Durch diese Anordnung lassen sich Fertigungstoleranzen bei der Anbringung des Substrates 27 am Dauermagneten 13 sowie Montagetoleranzen bei der Anbringung des Sensors 26 und des Zahnkranzes 28 ausgleichen.

Bei dieser Anordnung könnte sich jedoch als nachteilig erweisen, daß das Magnetfeld des Dauermagneten 26 zu beiden Seiten, d. h. zu den Enden der Nut 17 hin Feldkomponenten parallel zur Nut aufweist, so daß bereits ohne den Zahnkranz 28 die tangentiale Feldkomponente Ht1 und Ht2 an den beiden Brückenschaltungen 18, wie Figur 8 zeigt, etwas gegeneinander verdreht sind. Um auch diese Unparallelität des Magnetfeldes H kompensieren zu können, wird die in Figur 10 dargestellte Schaltungsanordnung verwendet. Hier wird über eine Eingangsstufe 32 eine stabilisierte Gleichspannung zur Versorgung der beiden Brückenschaltungen 18 erzeugt. Die Meßspannung $\triangle U1$ der ersten Brückenschaltung 18 wird einem Operationsverstärker 33 und die Meßspannung $\triangle U2$ der zweiten Brückenschaltung 18 wird einem weiteren Operationsverstärker 34 zugeführt. Ferner wird aus je einem Brückenzweig 18' und 18" der beiden Brückenschaltungen 18 eine weitere Brückenschaltung gebildet, wobei auf dem Substrat 27 der betroffene Brückenzweig 18' der einen Brückenschaltung 18 und der betroffene Brückenzweig 18" der anderen Brückenschaltung 18 im Mittel symmetrisch zum Halbierungspunkt der Nutlänge liegen müssen. Die Meßspannung $\triangle U3$ dieser dritten Brückenschaltung 18'/18"

schließlich zur Kompensation der vorgenannten Feldunparallelität als weitere Störgröße einem dritten Operationsverstärker 35 zugeführt. Die Ausgänge der Oberationsverstärker 33, 34 und 35 sind nun mit der Verknüpfungsschaltung 31 verbunden, in der zur Gewinnung der Meßspannung $\triangle U$ die Meßspannungen $\triangle U1$, $\triangle U2$ und $\triangle U3$ nach dem Algorithmus $\triangle U = \triangle U1 + 2 \cdot \triangle U3 + \triangle U2$ miteinander verknüpft sind. Bei Verwendung der anderen möglichen Brücke mit den zwei äußeren Brückenzweigen lautet der Algorithmus $\triangle U = \triangle U1 - 2 \cdot \triangle U3 + \triangle U2$. Allgemein gilt: $\triangle U = \triangle U1 + (-1)^k \cdot 2 \cdot \triangle U3 + \triangle U2$, wobei je nach den verwendeten Brückenzweigen bzw. nach der Polarität des Offsetteiles der Spannung $\triangle U3$ in bezug auf $\triangle U1$ bzw. $\triangle U2$ ein Exponent $\underline{k}$ zu wählen ist, der im Beispielsfall 1 bzw. 2 beträgt.

Die Erfindung ist nicht auf die dargestellten Ausführungsbeispiele beschränkt, da sowohl in der Ausbildung des Dauermagneten 13 und der Anordnung der Meßstreifen 10 als auch in der konstruktiven Ausbildung und Anordnung eines zum Dauermagneten relativ bewegten ferromagnetischen Körpers Änderungen möglich sind. Wesentlich ist jedoch, daß durch eine starke senkrecht durch die Meßstreifen 10 hindurchtretende Komponente des Magnetfeldes das zu detektierende ferromagnetische Material (Zahnkranz) magnetisiert wird und der Sensor aufgrund der tangentialen Komponente Hx gegen Störfelder weitgehend unempfindlich ist, daß die Meßstreifen 10 in einem Bereich des Magnetfeldes angeordnet sind, der eine weitgehend homogene Feldkomponente Ht in der Ebene der Meßstreifen 10 aufweist und daß sich die Richtung dieser Feldkomponente Ht durch eine Relativbewegung des Magnetfeldes H durch den ferromagnetischen Körper zur Erzeugung eines Meßsignales ändert. Dabei kann der ferromagnetische Körper auch als Dauermagnet ausgebildet sein. Anstelle eines Zahnkranzes 28 zur Drehzahlerfassung von Maschinen und dgl. könnte auch eine Zahnstange zur Wegmessung verwendet werden. Auch die Meßstreifen 10 können abweichend von Figur 6 in einer anderen Konfiguration auf einem Substrat angeordnet werden, sofern die Feldkomponente Ht im Bereich der Meßstreifen 10 eine weitgehend homogene Feldstärke aufweist. Zur Erzielung kurzer Leitungsverbindungen an der Auswerteschaltung ist es ferner möglich, diese zusammen mit den Brückenschaltungen 18 auf dem Substrat 27 unterzubringen.

**Patentansprüche**

1. Magnetoresistiver Sensor zur Abgabe von elektrischen Signalen aus magnetoresistiven, von einem Meßstrom durchflossenen Meßstreifen (10, 10a), die auf einem ortsfesten Substrat aufgebracht sind und deren Widerstand sich in Abhängigkeit von der Änderung einer in der Ebene der Meßstreifen liegenden Komponente des Gleichfeldes eines Magneten (13) ändert, die mit der Stromrichtung in den Meßstreifen einen Winkel bildet, wobei das Gleichfeld mit einer großen Feldkomponente senkrecht zu den Meßstreifen und mit einer kleinen Feldkomponente in der Ebene der Meßstreifen (10, 10a) verläuft, dadurch gekennzeichnet,

a) daß der Magnet (13) ortsfest angeordnet ist und an einer Polfläche eine Kante (16) aufweist,

b) daß ein zu detektierender ferromagnetischer Körper (14, 29) mit Abstand (y1) von der Polfläche parallel zu dieser Kante (16) bewegbar ist, und

c) daß das Substrat (12) mit den Meßstreifen (10, 10a) parallel zur Polfläche des Magneten (13) zwischen Magnet (13) und Bewegungsebene des ferromagnetischen Körpers (14, 29) so angeordnet ist, daß die Meßstreifen (10, 10a) durch eine in der Ebene der Meßstreifen (10, 10a) unter einem Winkel ($\alpha$) von etwa 45° zur Stromrichtung (I) in den Meßstreifen (10, 10a) verlaufende Feldkomponente (Ht) des Gleichfeldes (H) gesättigt sind und so, daß diese Feldkomponente (Ht) ihre Richtung durch Annäherung des ferromagnetischen Körpers (14, 29) an das stationäre Gleichfeld (H) zur Erzeugung eines Sensorsignales ändert.

2. Sensor nach Anspruch 1, dadurch gekennzeichnet, daß das Substrat (12, 27) mit den Meßstreifen (10, 10a) von der Stirnseite des Dauermagneten (13) einen Abstand ($y_0$) hat, der kleiner ist als der Abstand ($y_1 - y_0$) der Meßstreifen (10, 10a) zu dem am Dauermagneten (13) vorbeizubewegenden ferromagnetischen Körper (14, 29).

3. Sensor nach Anspruch 2, dadurch gekennzeichnet, daß die Kante (16) am Dauermagneten (13) durch eine Nut (17) gebildet ist, die sich in der Bewegungsrichtung (Z) des ferromagnetischen Körpers (14, 29) über die ganze Stirnseite des Dauermagneten (13) erstreckt.

4. Sensor nach Anspruch 3, dadurch gekennzeichnet, daß zur Drehzahlmessung der ferromagnetische Körper (14, 29) durch einen Zahn eines umlaufenden Körpers (15, 28) gebildet ist.

5. Sensor nach einem der vorherigen Ansprüche, dadurch gekennzeichnet, daß die Meßstreifen (10, 10a) zu vier Widerständen (19, 19a) zusammengefaßt sind, die in einer Brückenschaltung angeordnet in den vier Quadranten eines quadratischen Bereiches (20) des Substrates (12, 12a) aufgebracht sind.

6. Sensor nach Anspruch 5, dadurch gekennzeichnet, daß die in der Ebene der Meßstreifen (10, 10a) liegende Feldkomponente (Ht) des Magnetfeldes (H) im Bereich der Widerstände (19) eine weitgehend homogene Feldstärke aufweist.

7. Sensor nach Anspruch 6, dadurch gekennzeichnet, daß die Widerstände (19) der Brückenschaltung (18) aus mäanderförmig in Reihe liegende Meßstreifen (10) bestehen, die in ihrer Längsrichtung zu den Meßstreifen der benachbarten Widerstände (19) um 90° gedreht sind.

8. Sensor nach Anspruch 6, dadurch gekennzeichnet, daß die Widerstände (19) der Brückenschaltung (18) aus in Reihe liegende Meßstreifen (10a) bestehen, deren Längsrichtung mit den Meßstreifen der benachbarten Widerstände (19) gleich ist, die durch elektrisch gut leitende Fäden (24) in Bahnabschnitte (25) aufgegliedert sind, welche unter 45° zur Längsrichtung der Meßstreifen (10a) und unter 90° zu den Fäden (24) auf den Meßstreifen (10a) der benachbarten Widerstände (19) verlaufen.

9. Sensor nach Anspruch 1 und 5, dadurch gekennzeichnet, daß im Bereich der Kante (16) des Dauermagneten (13) auf dem Substrat (27) zwei mit Abstand (a) in bezug auf die Bewegungsrichtung des ferromagnetischen Körpers (14, 29) hintereinanderliegende Brückenschaltungen (18) angeordnet sind.

10. Sensor nach Anspruch 9, dadurch gekennzeichnet, daß der Mittenabstand (a) der beiden Brückenschaltungen (18) etwa gleich der Zahnbreite (b) an einem den ferromagnetischen Körper bildenden, umlaufenden Zahnkranz (28) ist, dessen Zähne (29) und Zahnlücken (28) gleich breit sind.

11. Sensor nach Anspruch 9 oder 10, dadurch gekennzeichnet, daß jeweils der Brückenzweig (18') einer Brückenschaltung (18), welcher einem Brückenzweig (18") der anderen Brückenschaltung (18) symmetrisch zum Halbierungspunkt der Nutlänge gegenüberliegt, mit diesem zu einer dritten Brückenschaltung (18', 18") verbunden ist.

12. Sensor nach Anspruch 11, dadurch gekennzeichnet, daß die Meßspannungen ($\Delta U1$, $\Delta U2$, $\Delta U3$) an den drei Brückenschaltungen (18 und 18', 18") zur Kompensation von Störgrößen in einer Auswerteschaltung (31) nach einem Algorithmus $\Delta U = \Delta U1 + (-1)^k \cdot 2 \cdot \Delta U3 + \Delta U2$, mit $k = 1$ bzw. 2, miteinander verknüpft sind, wobei $\Delta U$ die Meßspannung nach der Verknüpfung, $\Delta U1$ die Meßspannung an der ersten, $\Delta U2$ die Meßspannung an der zweiten und $\Delta U3$ die Meßspannung an der dritten Brückenschaltung (18; 18', 18") und $\underline{k}$ ein Exponent mit dem Wert 1 bzw. 2 ist.

## Claims

1. Magneto-resistive sensor for producing electric signals from magneto-resistive sensing strips (10, 10a) through which a sensing current flows and which are applied to a stationary substrate and the resistance of which changes as a function of the change of a component of the direct-current field of a magnet (13), which is located in the plane of the sensing strips, which component forms an angle with the direction of the current in the sensing strips, the direct-current field extending perpendicularly to the sensing strips with a large field component and extending in the plane of the sensing strips (10, 10a) with a small field component, characterized in that

a) the magnet (13) is arranged to be stationary and exhibits an edge (16) at one pole face,

b) that a ferromagnetic body (14, 29) to be detected can be moved parallel to this edge (16) at a distance (y1) from the pole face and

c) that the substrate (12) with the sensing strips (10, 10a) is arranged parallel to the pole face of the magnet (13) between magnet (13) and plane of movement of the ferromagnetic body (14, 29) in such a manner that the sensing strips (10, 10a) are saturated by a field component (Ht) of the direct-current field (H) extending in the sensing strips (10, 10a) in the plane of the sensing strips (10, 10a) at an angle ($\alpha$) of about 45° with respect to the direction of the current (I), and that this field component (Ht) changes its direction due to the approach of the ferromagnetic body (14, 29) to the stationary direct-current field (H) for generating a sensor signal.

2. Sensor according to Claim 1, characterized in that the substrate (12, 27) with the sensing strips (10, 10a) has a distance ($y_0$) from the front face of the permanent magnet (13), which is smaller than the distance ($y_1 - y_0$) of the sensing strips (10, 10a) from the ferromagnetic body (14, 29) to be moved past the permanent magnet (13).

3. Sensor according to Claim 2, characterized in that the edge (16) at the permanent magnet (13) is formed by a groove (17) which extends over the entire front face of the permanent magnet (13) in the direction of movement (Z) of the ferromagnetic body (14, 29).

4. Sensor according to Claim 3, characterized in that the ferromagnetic body (14, 29) is formed by a tooth of a rotating body (15, 28) for measuring rotational speed.

5. Sensor according to one of the preceding claims, characterized in that the sensing strips (10, 10a) are combined to form four resistors (19, 19a) which, arranged in a bridge circuit, are applied in the four quadrants of a square area (20) of the substrate (12, 12a).

6. Sensor according to Claim 5, characterized in that the field component (Ht) of the magnetic field (H), which is located in the plane of the sensing strips (10, 10a) exhibits a largely homogeneous field strength in the area of the resistors (19).

7. Sensor according to Claim 6, characterized in that the resistors (19) of the bridge circuit (18) consist of sensing strips (10) which are located in series in the form of a meander and which are rotated by 90° in their longitudinal direction with respect to the sensing strips of the adjacent resistors (19).

8. Sensor according to Claim 6, characterized in that the resistors (19) of the bridge circuit (18) consist of series-connected sensing strips (10a), the longitudinal direction of which is identical to the sensing strips of the adjacent resistors (19) which are divided into path sections (25) by threads (24) with good electric conductance, which extend at 45° with respect to the longitudinal direction of the sensing strips (10a) and at 90° with respect to the threads (24) on the sensing strips (10a) of the adjacent resistors (19).

9. Sensor according to Claim 1 and 5, characterized in that two bridge circuits (18), which are located behind one another at a distance (a) with respect to the direction of movement of the ferromagnetic body (14, 29) are arranged on the substrate (27) in the area of the edge (16) of the permanent magnet (13).

10. Sensor according to Claim 9, characterized in that the centre distance (a) of the two bridge circuits (18) is approximately equal to the tooth width (b) at a rotating toothed wheel (28) which forms the ferromagnetic body, of which the teeth (29) and tooth gaps (28) are of equal width.

11. Sensor according to Claim 9 or 10, characterized in that in each case the bridge branch (18') of a bridge circuit (18), which is symmetrically opposite to the half-way point of the groove length to a bridge branch (18") of the other bridge circuit (18), is connected to the latter to form a third bridge circuit (18', 18").

12. Sensor according to Claim 11, characterized in that the measurement voltages ($\triangle U1$, $\triangle U2$, $\triangle U3$) across the three bridge circuits (18 and 18', 18") are combined with one another in accordance with an algorithm $\triangle U = \triangle U1 + (1)^k \cdot 2 \cdot \triangle U3 \triangle U2$, where k = 1 or 2, respectively, in an evaluating circuit (31) for compensating interference variables, where $\triangle U$ is the measurement voltage after the combination, $\triangle U$ is the measurement voltage across the first, $\triangle U2$ is the measurement voltage across the second and $\triangle U3$ is the measurement voltage across the third bridge circuit (18, 18', 18") and $\underline{k}$ is an exponent having the value 1 or 2, respectively.

**Revendications**

1. Détecteur à magnétorésistance pour fournir des signaux électriques à partir de bandes de mesure (10, 10a), magnétorésistantes, traversées par un courant de mesure, ces bandes étant prévues sur un support fixe et leur résistance variant suivant la variation de la composante du champ continu d'un aimant (13), composante située dans le plan des bandes de mesure, composante qui forme un angle avec la direction du courant dans les bandes de mesure et le champ continu offre une composante de champ intense perpendiculaire aux bandes de mesure et une faible composante de champ dans le plan des bandes de mesure (10, 10a), détecteur caractérisé en ce que:

a) l'aimant (13) est fixe et présente une arête (16) sur une surface polaire,

b) une pièce ferromagnétique (14, 29) à détecter, se déplace à la distance (y1) de la surface polaire, parallèlement à cette arête (16), et

c) le support (12) et les bandes de mesure (10, 10a) sont placés parallèlement à la surface polaire de l'aimant (13) entre cet aimant (13) et le plan de déplacement de la pièce ferromagnétique (14, 29), les bandes de mesure (10, 10a) étant saturées par une composante (Ht) du champ continu (H) qui est contenu dans le plan des bandes de mesure (10, 10a) et fait un angle ($\alpha$) d'environ 45° par rapport à la direction du courant (2) dans les bandes de mesure (10, 10a) et cette composante de champ (Ht) change de direction lorsque la pièce ferromagnétique (14, 29) se rapproche du champ continu fixe (H) pour créer un signal de détection.

2. Détecteur selon la revendication 1, caractérisé en ce que le support (12, 27) portant les bandes de mesure (10, 10a) est distant d'une distance (y0) par rapport à la face frontale de l'aimant permanent (13), distance qui est inférieure à la distance (y1 - y0) des bandes de mesure (10, 10a) par rapport à la pièce ferromagnétique (14, 29) qui passe devant l'aimant permanent (13).

3. Capteur selon la revendication 2, caractérisé en ce que l'arête (16) est formée par une rainure (17) dans l'aimant permanent (13), rainure qui s'étend dans la direction de déplacement (Z) de la pièce ferromagnétique (14, 29) sur toute la surface frontale de l'aimant permanent (13).

4. Détecteur selon la revendication 3, caractérisé en ce que pour la mesure de la vitesse de rotation de la pièce ferromagnétique (14, 29) on a une pièce en rotation avec une dent (15, 28).

5. Détecteur selon l'une des revendications précédentes, caractérisé en ce que les bandes de mesure (10, 10a) sont réunies pour former quatre résistances (19, 19a) combinées suivant un montage en pont, ces résistances se trouvant dans les quatre cadrans d'une zone carrée (20) du support (12, 12a).

6. Capteur selon la revendication 5, caractérisé en ce que la composante de champ (Ht) du champ magnétique (H) situé dans le plan des bandes de mesure (10, 10a) présente une intensité de champ très homogène dans la zone des résistances (19).

7. Détecteur selon la revendication 6, caractérisé en ce que les résistances (19) du montage en pont (18) se composent de bandes de mesure (10) réunies en série suivant un tracé en méandres, bandes dont la direction longitudinale est tournée à 90° par rapport à la direction longitudinale des bandes de mesure des résistances voisines (19).

8. Détecteur selon la revendication 6, caractérisé en ce que les résistances (19) du montage en pont (18) sont formées de bandes de mesure en série dont la direction longitudinale est égale à celle des bandes de mesure des résistances voisines (19) et qui sont subdivisées en des segments (25) par des fils (24) bons conducteurs d'électricité, ces fils ayant un trace à 45° par rapport à la direction longitudinale des bandes de mesure (10a) et à 90° par rapport aux fils (24) des bandes de mesure (10a) de la résistance voisine (19).

9. Détecteur selon les revendications 1 et 5, caractérisé en ce qu'au niveau de l'arête (16) de l'aimant permanent (13) sur le substrat (27) on a deux montages en pont (18) distants de la distance (a), l'un derrière l'autre par rapport à la direction de déplacement de la pièce ferromagnétique (14, 29).

10. Détecteur selon la revendication 9, caractérisé en ce que l'intervalle (a) séparant les deux montages en pont (18) est sensiblement égal à la largeur (b) d'une dent d'une couronne dentée (28) en rotation, constituant la pièce ferromagnétique, les dents (29) et les intervalles (28) des dents étant de même longueur.

11. Détecteur selon la revendication 9 ou la revendication 10, caractérisé en ce que la branche (18') d'un montage en pont (18) qui est symétrique par rapport à la branche (18") de l'autre montage en pont (18), par rapport au milieu de la longueur de la rainure, est reliée pour former un troisième montage en pont (18', 18").

12. Détecteur selon la revendication 11, caractérisé en ce que les tensions de mesure ($\Delta U1$, $\Delta U2$, $\Delta U3$) des deux montages en pont (18 et 18', 18") sont combinées pour compenser les grandeurs parasites suivant un circuit d'exploitation (31) correspondant à un algorithme $\Delta U = \Delta U1 + (-1)^k \cdot 2 \cdot \Delta U3 + \Delta U2$, (k = 1 ou 2) et $\Delta U$ représente la tension de mesure de la combinaison réalisée, $\Delta U1$ la tension de mesure d'un premier montage en pont, $\Delta U2$ la tension de mesure d'un second montage en pont et $\Delta U3$ la tension de mesure d'un troisième montage en pont (18, 18', 18") et $\underline{k}$ étant un exposant de valeur 1 ou 2.

FIG.1

FIG 2

FIG. 3

FIG.4

FIG.5

FIG.6

FIG.7

FIG.8

FIG.9

FIG.10